# EUROPEAN PATENT SPECIFICATION

(11) **EP 3 716 076 B1**
(45) Date of publication and mention of the grant of the patent: **07.09.2022**
(21) Application number: 20161581.2
(22) Date of filing: 06.03.2020
(51) Int. Cl.: G06F 12/02, G06F 17/16, G06F 9/50, G06N 3/04, G06N 3/063, G06N 3/08, G11C 11/4096, G11C 7/10, G11C 8/12

(54) **TECHNOLOGIES FOR PROVIDING HIGH EFFICIENCY COMPUTE ARCHITECTURE ON CROSS POINT MEMORY FOR ARTIFICIAL INTELLIGENCE OPERATIONS**
TECHNOLOGIEN ZUR BEREITSTELLUNG EINER HOCHEFFIZIENTEN RECHENARCHITEKTUR AUF DEM KREUZPUNKTSPEICHER FÜR OPERATIONEN MIT KÜNSTLICHER INTELLIGENZ
TECHNOLOGIES POUR FOURNIR UNE ARCHITECTURE INFORMATIQUE HAUTE EFFICACITÉ SUR UNE MÉMOIRE DE POINT DE CROISEMENT POUR DES OPÉRATIONS D'INTELLIGENCE ARTIFICIELLE

(30) Priority: 29.03.2019 US 201916370011
(43) Date of publication of application: 30.09.2020
(73) Proprietor: Intel Corporation, Santa Clara, CA 95054 (US)
(72) Inventor: SRINIVASAN, Srikanth, Portland, OR 97229 (US); SUNDARAM, Rajesh, Folsom, CA 95630 (US); KHAN, Jawad B., Portland, OR 97229 (US); TOMISHIMA, Shigeki, Portland, OR 97229 (US); VANGAL, Sriram, Portland, OR 97229 (US); CHAUHAN, Chetan, Folsom, CA 95630 (US)
(74) Representative: Rummler, Felix

(56) References cited:
- EP-A1- 3 447 653
- US-A1- 2018 107 630
- US-A1- 2018 189 236

## Description

### BACKGROUND

In typical compute devices that perform tensor operations (e.g., matrix calculations, such as matrix multiplication) to support artificial intelligence applications (e.g., processes that utilize neural networks to make inferences), matrix data is transferred between the memory (e.g., dynamic random access memory (DRAM)) through a bus, to a processor and back. The processor may include static random access memory (SRAM) and may perform the tensor operations on the matrix data in the (SRAM), once the data has been sent through the bus. The transfer of the matrix data through the bus is energy intensive and is a bottleneck to the overall speed and efficiency with which the tensor operations can be performed.

Document US 2018/107630 discloses a computer architecture for parallelizing matrix multiplication operations for deep learning, involving data transfers between a processor and an external memory.

### BRIEF DESCRIPTION OF THE DRAWINGS

The invention is defined by the appended claims. The dependent claims define particular embodiments.

The concepts described herein are illustrated by way of example and not by way of limitation in the accompanying figures. For simplicity and clarity of illustration, elements illustrated in the figures are not necessarily drawn to scale. Where considered appropriate, reference labels have been repeated among the figures to indicate corresponding or analogous elements.
FIG. 1 is a simplified diagram of at least one embodiment of a compute device for efficiently performing artificial intelligence operations in memory;
FIG. 2 is a simplified diagram of at least one embodiment of a memory media included in the compute device of FIG. 1;
FIG. 3 is a simplified diagram of at least one embodiment of partitions of the memory media and components of a media access circuitry of a memory included in the compute device of FIG. 1;
FIG. 4 is a simplified diagram of at least one embodiment of a tensor operation that may be performed in the memory of the compute device of FIG. 1;
FIGS. 5-8 are simplified diagrams of at least one embodiment of a method for performing efficient artificial intelligence operations in memory that may be performed by the compute device of FIG. 1;
FIG. 9 is a simplified block diagram of reading weight matrix data into a corresponding scratch pad in a memory of the compute device of FIG. 1;
FIG. 10 is a simplified block diagram of matrices utilized in a matrix multiplication operation that may be performed in the memory of the compute device of FIG. 1;
FIG. 11 is a simplified block diagram of reading input matrix data and broadcasting the read input matrix data during the matrix multiplication operation performed in the memory of the compute device of FIG. 1;
FIG. 12 is a simplified block diagram indicating a flow of matrix data to produce an output matrix during the matrix multiplication operation performed in the memory of the compute device of FIG. 1; and
FIGS. 13-15 are simplified block diagrams of locations of matrix data over time as the matrix multiplication operation is performed in the memory of the compute device of FIG. 1.

### DETAILED DESCRIPTION OF THE DRAWINGS

While the concepts of the present disclosure are susceptible to various modifications and alternative forms, specific embodiments thereof have been shown by way of example in the drawings and will be described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

References in the specification to "one embodiment," "an embodiment," "an illustrative embodiment," etc., indicate that the embodiment described may include a particular feature, structure, or characteristic, but every embodiment may or may not necessarily include that particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described. Additionally, it should be appreciated that items included in a list in the form of "at least one A, B, and C" can mean (A); (B); (C); (A and B); (A and C); (B and C); or (A, B, and C). Similarly, items listed in the form of "at least one of A, B, or C" can mean (A); (B); (C); (A and B); (A and C); (B and C); or (A, B, and C).

The disclosed embodiments may be implemented, in some cases, in hardware, firmware, software, or any combination thereof. The disclosed embodiments may also be implemented as instructions carried by or stored on a transitory or non-transitory machine-readable (e.g., computer-readable) storage medium, which may be read and executed by one or more processors. A machine-readable storage medium may be embodied as any storage device, mechanism, or other physical structure for storing or transmitting information in a form readable by a machine (e.g., a volatile or non-volatile memory, a media disc, or other media device).

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features.

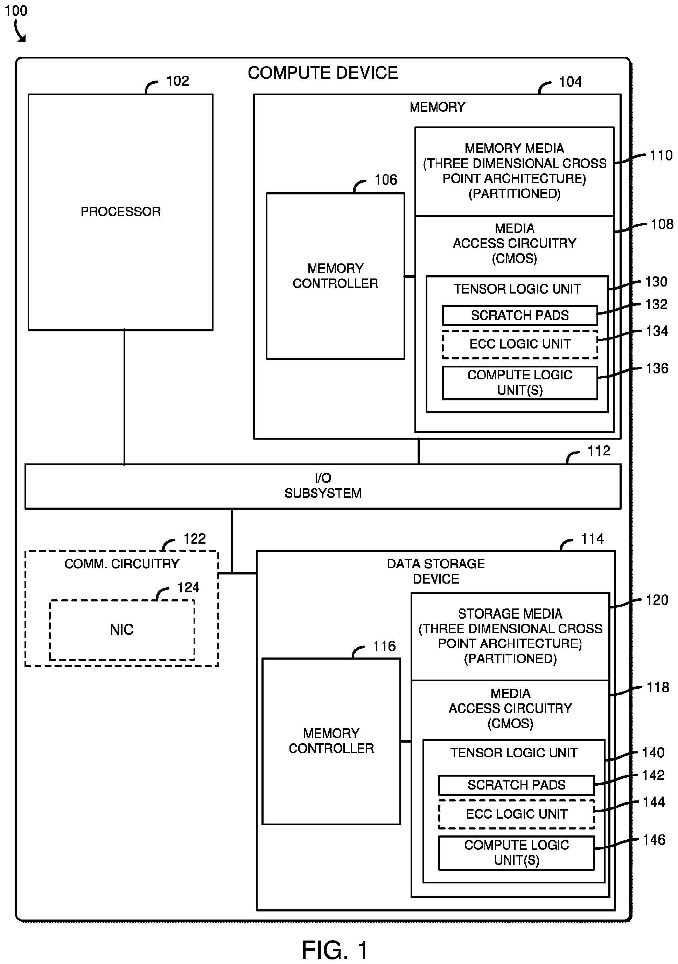

Referring now to FIG. 1, a compute device 100 for efficiently performing artificial intelligence operations (e.g., tensor operations) in memory includes a processor 102, memory 104, an input/output (I/O) subsystem 112, a data storage device 114, and communication circuitry 122. Of course, in other embodiments, the compute device 100 may include other or additional components, such as those commonly found in a computer (e.g., a display, peripheral devices, etc.). Additionally, in some embodiments, one or more of the illustrative components may be incorporated in, or otherwise form a portion of, another component. As described herein, the compute device 100, and in particular, the memory 104 of the compute device 100 enables artificial intelligence operations (e.g., tensor operations, such as matrix calculations) to be performed more efficiently than in conventional compute devices by performing the operations in the memory 104. As described in more detail herein, in the illustrative embodiment, the memory 104 includes media access circuitry 108 configured to access the memory media 110 to perform the artificial intelligence operations. The memory media 110, in the illustrative embodiment, has a three-dimensional cross point architecture that has data access characteristics that differ from other memory architectures (e.g., dynamic random access memory (DRAM)), such as enabling access to one bit per tile and incurring time delays between reads or writes to the same partition or other partitions. The media access circuitry 108 is configured to make efficient use (e.g., in terms of power usage and speed) of the architecture of the memory media 110, such as by accessing multiple tiles in parallel within a given partition, utilizing scratch pads (e.g., relatively small, low latency memory) to temporarily retain and operate on data read from the memory media 110, and broadcasting data read from one partition to other portions of the memory 104 to enable matrix calculations to be performed in parallel within the memory 104. Additionally, in the illustrative embodiment, instead of sending read or write requests to the memory 104 to access matrix data, the processor 102 may send a higher-level request (e.g., a type of matrix calculation to perform) and provide the locations and dimensions (e.g., in memory) of the matrices to be utilized in the requested operation (e.g., an input matrix, a weight matrix, and an output matrix). Further, rather than sending back the resulting data to the processor 102, the memory 104 may merely send back an acknowledgement (e.g., "Done"), indicating that the requested operation has been completed. As such, many artificial intelligence operations can be performed in memory 104, with minimal usage of the bus between the processor 102 and the memory 104. In some embodiments the media access circuitry 108 is included in the same die as the memory media 110. In other embodiments, the media access circuitry 108 is on a separate die but in the same package as the memory media 110. In yet other embodiments, the media access circuitry 108 is in a separate die and separate package but on the same dual in-line memory module (DIMM) or board as the memory media 110.

The processor 102 may be embodied as any device or circuitry (e.g., a multicore processor(s), a microcontroller, or other processor or processing/controlling circuit) capable of performing operations described herein, such as executing an application (e.g., an artificial intelligence related application that may utilize a neural network or other machine learning structure to learn and make inferences). In some embodiments, the processor 102 may be embodied as, include, or be coupled to an FPGA, an application specific integrated circuit (ASIC), reconfigurable hardware or hardware circuitry, or other specialized hardware to facilitate performance of the functions described herein.

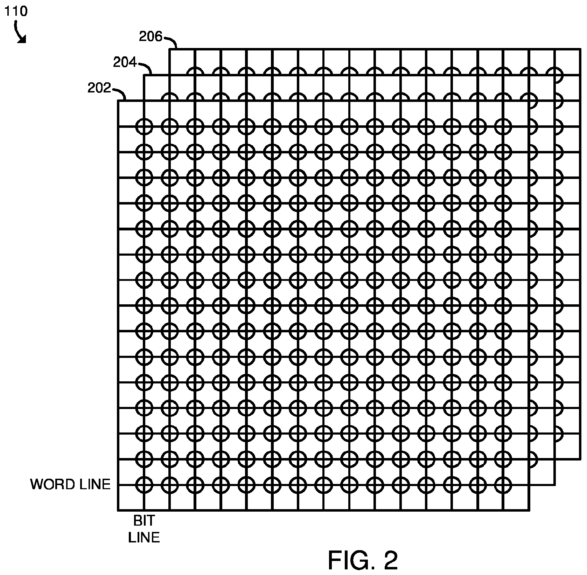

The memory 104, which may include a non-volatile memory (e.g., a far memory in a two-level memory scheme), includes a memory media 110 and media access circuitry 108 (e.g., a device or circuitry, such as integrated circuitry constructed from complementary metal-oxide-semiconductors (CMOS) or other materials) underneath (e.g., at a lower location) and coupled to the memory media 110. The media access circuitry 108 is also connected to a memory controller 106, which may be embodied as any device or circuitry (e.g., a processor, a co-processor, dedicated circuitry, etc.) configured to selectively read from and/or write to the memory media 110 and to perform tensor operations on data (e.g., matrix data) present in the memory media 110 (e.g., in response to requests from the processor 102, which may be executing an artificial intelligence related application that relies on tensor operations to train a neural network and/or to make inferences). Referring briefly to FIG. 2, the memory media 110, in the illustrative embodiment, includes a tile architecture, also referred to herein as a cross point architecture (e.g., an architecture in which memory cells sit at the intersection of word lines and bit lines and are individually addressable and in which bit storage is based on a change in bulk resistance), in which each tile (e.g., memory cell) is addressable by an x parameter and a y parameter (e.g., a column and a row). The memory media 110 includes multiple partitions, each of which includes the tile architecture. The partitions may be stacked as layers 202, 204, 206 to form a three-dimensional cross point architecture (e.g., Intel 3D XPoint^{™} memory). Unlike typical memory devices, in which only fixed-size multiple-bit data structures (e.g., byte, words, etc.) are addressable, the media access circuitry 108 is configured to read individual bits, or other units of data, from the memory media 110 at the request of the memory controller 106, which may produce the request in response to receiving a corresponding request from the processor 102.

Referring back to FIG. 1, the media access circuitry 108, in the illustrative embodiment, includes a tensor logic unit 130, which may be embodied as any device or circuitry (e.g., CMOS circuitry) configured to offload the performance of tensor operations from other portions of the media access circuitry 108. The tensor logic unit 130, in the illustrative embodiment, includes multiple memory scratch pads 132, each of which may be embodied as any device or circuitry (e.g., static random access memories (SRAMs), register files, etc.) usable to provide relatively fast (e.g., low latency) access to matrix data that has been read from the memory media 110. In the illustrative embodiment, the scratch pads 132 provide faster read and write access times than the memory media 110 which has comparatively slower access times and a larger capacity. The tensor logic unit 130 may additionally include an error correction code (ECC) logic unit 134, which may be embodied as any device or circuitry (e.g., reconfigurable circuitry, an application specific integrated circuit (ASIC), etc.) configured to determine whether data read from the memory media 110 contains errors and to correct any errors with error correction algorithm(s), such as Reed-Solomon codes or Bose-Chaudhuri-Hocquenghem (BCH) codes. Additionally, in the illustrative embodiment, the tensor logic unit 130 includes multiple compute logic units 136 each of which may be embodied as any device or circuitry (e.g., reconfigurable circuitry, ASICs, etc.) configured to perform tensor operations on matrix data in a corresponding set of scratch pads 132.

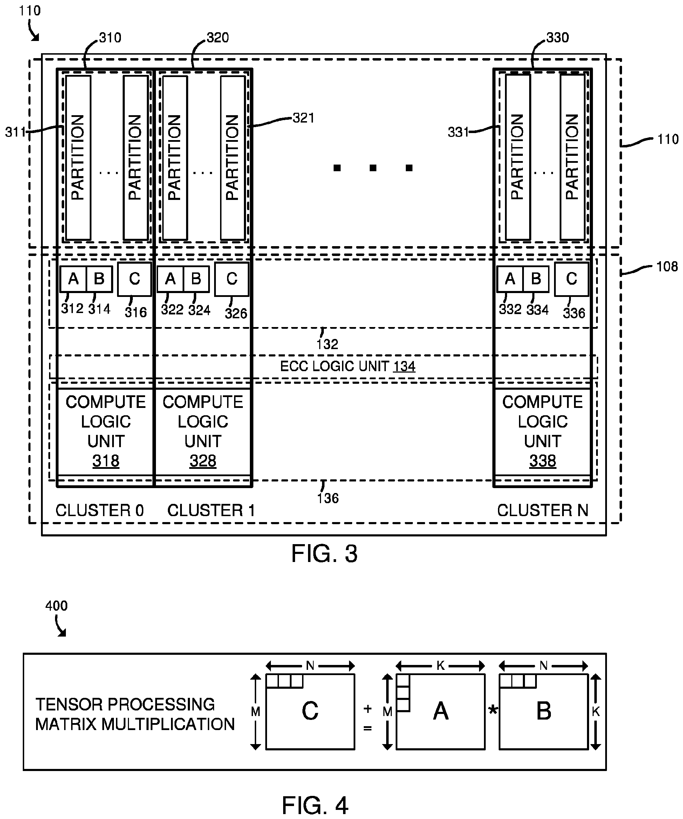

Referring briefly to FIG. 3, in the illustrative embodiment, components of the memory 104 are divided into clusters (e.g., groups of partitions) 310, 320, 330. The cluster 310 includes multiple partitions 311 of the memory media 110, a set of scratch pads 312, 314, 316, each similar to the scratch pads 132 of FIG. 1, and a corresponding compute logic unit 318, similar to the compute logic unit 136 of FIG. 1. Similarly, the cluster 320 includes another set of partitions 321 of the memory media 110, a corresponding set of scratch pads 322, 324, 326, and a corresponding compute logic unit 328. The cluster 330 also includes a set of partitions 331 of the memory media 110, a corresponding set of scratch pads 332, 334, 336, and a compute logic unit 338. In the illustrative embodiment, in operation, the compute logic unit 318 reads a subset of matrix data (e.g., one value of an input matrix A from the set of partitions (e.g., partitions 311)) into the corresponding scratch pad 312 and may broadcast that same subset of the matrix data to the corresponding scratch pads of the other clusters (e.g., to the scratch pads 322, 332). Similarly, the compute logic unit 328 may read, from the corresponding set of partitions 321 another subset of the matrix data (e.g., another value of the input matrix A) into the corresponding scratch pad 322 and broadcast that subset of the matrix data to the other scratch pads that are to store data for that matrix (e.g., to the scratch pads 312, 332). The compute logic unit 338 performs similar read and broadcast operations.

By broadcasting, to the other scratch pads, matrix data that has been read from a corresponding set of partitions of the memory media 110, the media access circuitry 108 reduces the number of times that a given section (e.g., set of partitions) of the memory media 110 must be accessed to obtain the same matrix data (e.g., the read matrix data may be broadcast to multiple scratch pads after being read from the memory media 110 once, rather than reading the same matrix data from the memory media 110 multiple times). Further, by utilizing multiple compute logic units 318, 328, 338 that are each associated with corresponding scratch pads 312, 314, 316, 322, 224, 226, 232, 234, 236, the media access circuitry 108 may perform the portions of a tensor operation (e.g., matrix multiply and accumulate) concurrently (e.g., in parallel). It should be understood that while three clusters 310, 320, 330 are shown in FIG. 3 for simplicity, the actual number of clusters and corresponding partitions, scratch pads, and compute logic units may differ depending on the particular embodiment.

Referring briefly to FIG. 4, an example of a matrix multiplication (e.g., matrix multiply and accumulate) operation 400 that may be performed by the memory 104 is shown. As illustrated, matrix data in an input matrix A is multiplied by matrix data in another matrix B (e.g., weight data for a layer of a convolutional neural network) and the resultant data is written to the output matrix C. Each matrix represented in FIG. 4 is temporarily stored as matrix data in the scratch pads 132 of the media access circuitry 108. In some embodiments, the output matrix C may be utilized as an input matrix for a subsequent tensor operation (e.g., as an input matrix for a subsequent layer of a convolutional neural network).

Referring back to FIG. 1, the memory 104 may include non-volatile memory and volatile memory. The non-volatile memory may be embodied as any type of data storage capable of storing data in a persistent manner (even if power is interrupted to the non-volatile memory). For example, the non-volatile memory may be embodied as one or more non-volatile memory devices. The non-volatile memory devices may include one or more memory devices configured in a cross point architecture that enables bit-level addressability (e.g., the ability to read from and/or write to individual bits of data, rather than bytes or other larger units of data), and are illustratively embodied as three-dimensional (3D) cross point memory. In some embodiments, the non-volatile memory may additionally include other types of memory, including any combination of memory devices that use chalcogenide phase change material (e.g., chalcogenide glass), ferroelectric transistor random-access memory (FeTRAM), nanowire-based non-volatile memory, phase change memory (PCM), memory that incorporates memristor technology, Magnetoresistive random-access memory (MRAM) or Spin Transfer Torque (STT)-MRAM. The volatile memory may be embodied as any type of data storage capable of storing data while power is supplied volatile memory. For example, the volatile memory may be embodied as one or more volatile memory devices, and is periodically referred to hereinafter as volatile memory with the understanding that the volatile memory may be embodied as other types of non-persistent data storage in other embodiments. The volatile memory may have an architecture that enables bit-level addressability, similar to the architecture described above.

The processor 102 and the memory 104 are communicatively coupled to other components of the compute device 100 via the I/O subsystem 112, which may be embodied as circuitry and/or components to facilitate input/output operations with the processor 102 and/or the main memory 104 and other components of the compute device 100. For example, the I/O subsystem 112 may be embodied as, or otherwise include, memory controller hubs, input/output control hubs, integrated sensor hubs, firmware devices, communication links (e.g., point-to-point links, bus links, wires, cables, light guides, printed circuit board traces, etc.), and/or other components and subsystems to facilitate the input/output operations. In some embodiments, the I/O subsystem 112 may form a portion of a system-on-a-chip (SoC) and be incorporated, along with one or more of the processor 102, the main memory 104, and other components of the compute device 100, in a single chip.

The data storage device 114 may be embodied as any type of device configured for short-term or long-term storage of data such as, for example, memory devices and circuits, memory cards, hard disk drives, solid-state drives, or other data storage device. In the illustrative embodiment, the data storage device 114 includes a memory controller 116, similar to the memory controller 106, storage media 120, similar to the memory media 110, and media access circuitry 118, similar to the media access circuitry 108, including a tensor logic unit 140, similar to the tensor logic unit 130, scratch pads 142, similar to the scratch pads 132, an ECC logic unit 144, similar to the ECC logic unit 134, and compute logic units 146, similar to the compute logic units 136. As such, in the illustrative embodiment, the data storage device 114 (e.g., the media access circuitry 118) is capable of efficiently performing tensor operations on matrix data stored in the storage media 120. The data storage device 114 may include a system partition that stores data and firmware code for the data storage device 114 and one or more operating system partitions that store data files and executables for operating systems.

The communication circuitry 122 may be embodied as any communication circuit, device, or collection thereof, capable of enabling communications over a network between the compute device 100 and another device. The communication circuitry 122 may be configured to use any one or more communication technology (e.g., wired or wireless communications) and associated protocols (e.g., Ethernet, Bluetooth^{®}, Wi-Fi^{®}, WiMAX, etc.) to effect such communication.

The illustrative communication circuitry 122 includes a network interface controller (NIC) 122, which may also be referred to as a host fabric interface (HFI). The NIC 124 may be embodied as one or more add-in-boards, daughter cards, network interface cards, controller chips, chipsets, or other devices that may be used by the compute device 100 to connect with another compute device. In some embodiments, the NIC 124 may be embodied as part of a system-on-a-chip (SoC) that includes one or more processors, or included on a multichip package that also contains one or more processors. In some embodiments, the NIC 124 may include a local processor (not shown) and/or a local memory (not shown) that are both local to the NIC 124. In such embodiments, the local processor of the NIC 124 may be capable of performing one or more of the functions of the processor 102. Additionally or alternatively, in such embodiments, the local memory of the NIC 124 may be integrated into one or more components of the compute device 100 at the board level, socket level, chip level, and/or other levels.

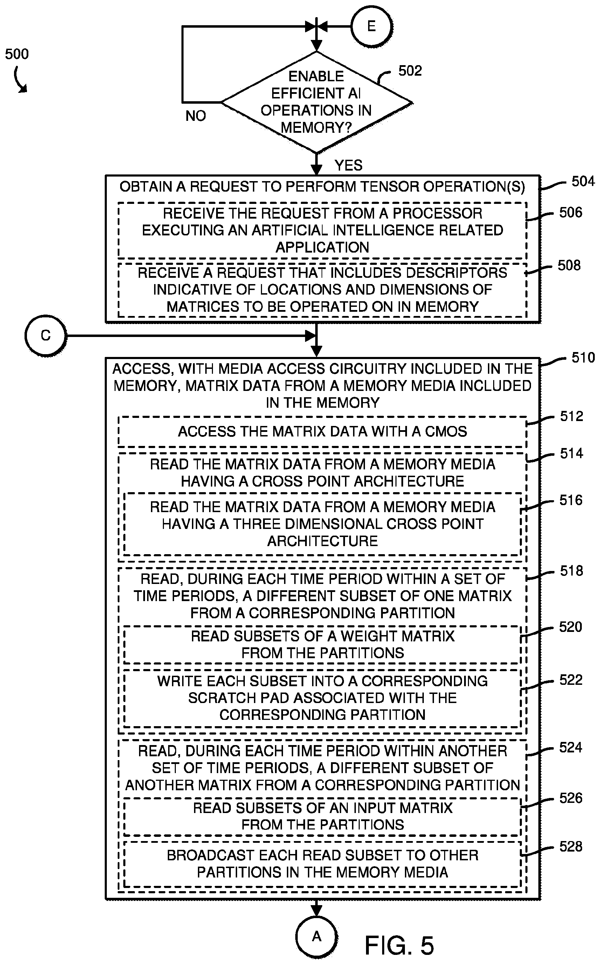

Referring now to FIG. 5, the compute device 100, in operation, may execute a method 500 for efficiently performing artificial intelligence operations (e.g., tensor operations) in memory (e.g., in the memory 104). The method 500 is described with reference to the memory 104. However, it should be understood that the method 500 could be additionally or alternatively performed using the memory of the data storage device 114. The method 500 begins with block 502 in which the compute device 100 (e.g., the memory 104) determines whether to enable the performance of efficient artificial intelligence operations (e.g., tensor operations) in the memory 104. The compute device 100 may enable the performance of efficient artificial intelligence operations in the memory 104 in response to a determination that the media access circuitry 108 includes the tensor logic unit 130, in response to a determination that a configuration setting (e.g., in a configuration file) indicates to enable the performance of tensor operations in memory, and/or based on other factors.

Regardless, in response to a determination to enable the performance of efficient artificial intelligence operations in the memory 104, the method 500 advances to block 504, in which the compute device 100 may obtain a request to perform one or more tensor operations. For example, and as indicated in block 506, the memory 104 (e.g., the media access circuitry 108) may receive the request from a processor (e.g., the processor 102), which may be executing an artificial intelligence related application (e.g., an application that may utilize a neural network or other machine learning structure to learn and make inferences). As indicated in block 508, the memory 104 (e.g., the media access circuitry 108) may receive a request that includes descriptors (e.g., parameters or other data) indicative of locations (e.g., addresses) and dimensions (e.g., the number of columns and the number of rows) of matrices to be operated on in the memory 104.

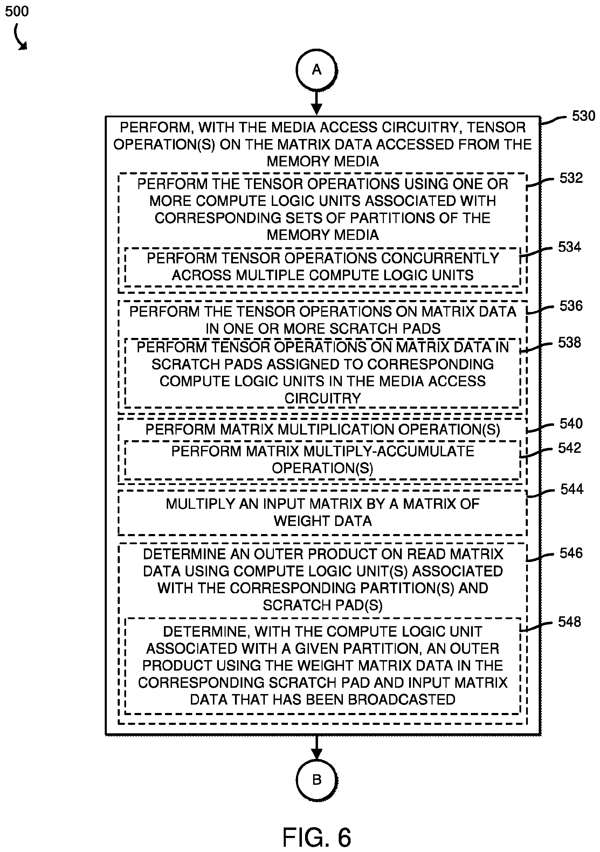

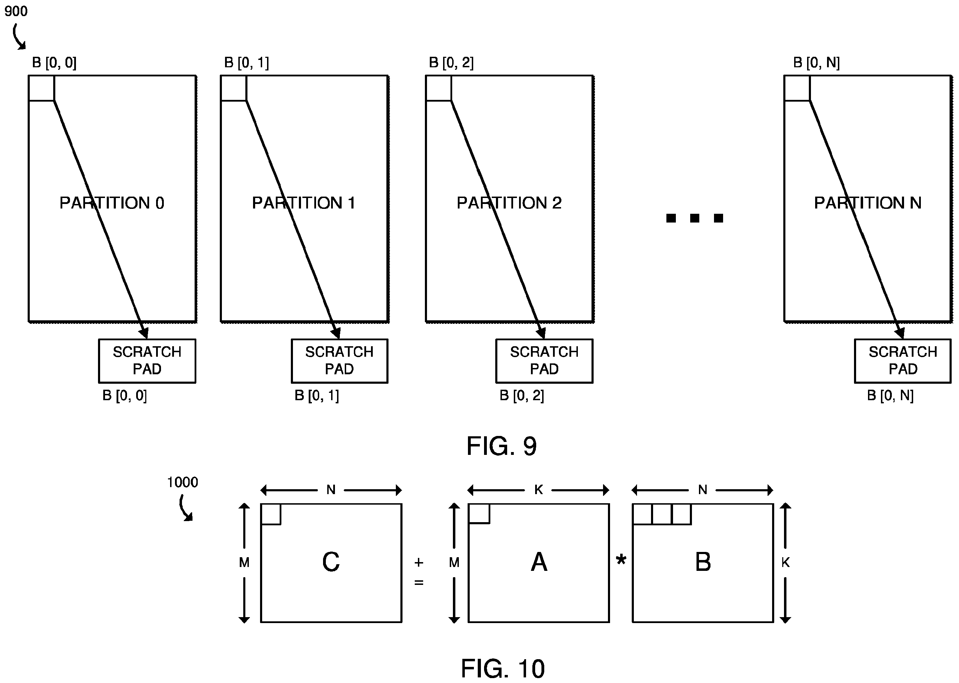

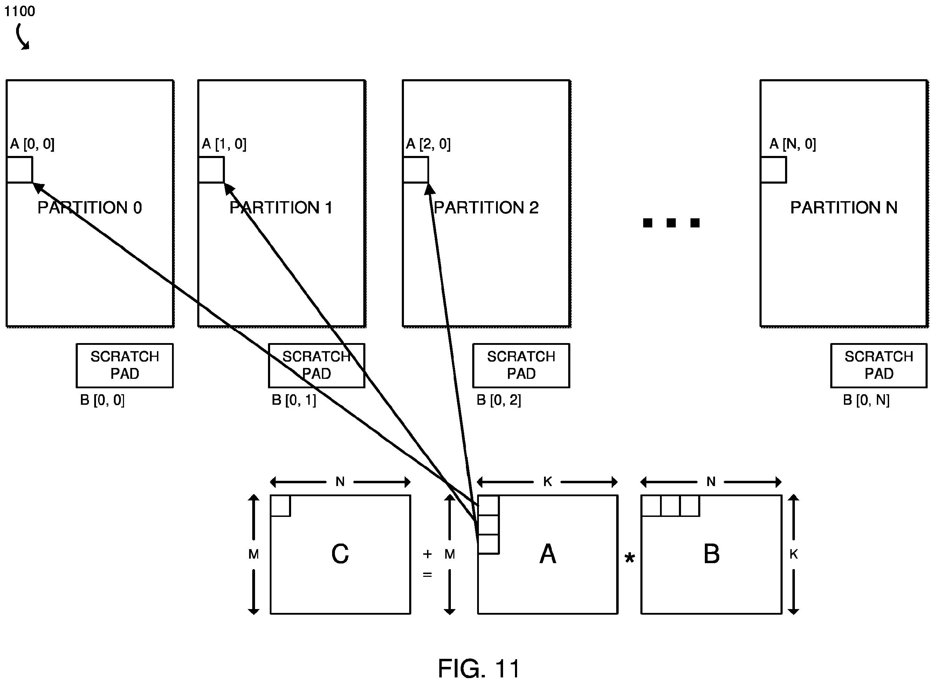

Subsequently, the method 500 advances to block 510 in which the compute device 100 accesses, with media access circuitry (e.g., the media access circuitry 108) included in the memory 104, matrix data from a memory media (e.g., the memory media 110) included in the memory 104. In the illustrative embodiment, the compute device 100 accesses the matrix data (e.g., from the memory media 110) with a complimentary metal oxide semiconductor (CMOS) (e.g., the media access circuitry 108 may be formed from a CMOS), as indicated in block 512. Additionally, and as indicated in block 514, in the illustrative embodiment, the memory 104 (e.g., the media access circuitry 108) reads the matrix data from a memory media (e.g., the memory media 110) having a cross point architecture (e.g., an architecture in which memory cells sit at the intersection of word lines and bit lines and are individually addressable and in which bit storage is based on a change in bulk resistance). Further, and as indicated in block 516, the media access circuitry 108 reads the matrix data from a memory media (e.g., the memory media 110) having a three dimensional cross point architecture (e.g., an architecture in which sets of tiles are stacked as layers, as described with reference to FIG. 2). As indicated in block 518, the compute device 100 reads, during each time period within a set of time periods (e.g., multiple successive time periods), a different subset (e.g., one matrix value) of a matrix from a corresponding partition (e.g., one partition per time period). In doing so, and as indicated in block 520, the compute device 100, and in particular, the media access circuitry 108, may read subsets of a weight matrix (e.g., matrix B) from the partitions. Further, and as indicated in block 522, the compute device 100, and in particular, the media access circuitry 108, writes each subset into a corresponding scratch pad associated with the corresponding partition (e.g., the scratch pad associated with the partition from which the subset of matrix B was read). Referring briefly to the diagrams 900, 1000 of FIGS. 9 and 10, over the first N (e.g., a number of partitions in the memory media 110) time periods of performing a matrix multiplication operation, values (e.g., subsets) of the weight matrix B are read by the media access circuitry 108, from the corresponding partitions, into the corresponding scratch pads associated with those partitions. Similarly, and with reference to the operations 1100 of FIG. 11, the compute device 100, in the illustrative embodiment, reads, during each time period within another set of time periods (e.g., a set of successive time periods following that set of time periods described with reference to block 518) a different subset of another matrix from a corresponding partition, as indicated in block 524. In the illustrative embodiment, and as indicated in block 526, the compute device 100 (e.g., the media access circuitry 108) reads subsets (e.g., one value per time period) of the input matrix A from the corresponding partitions. Further, in each time period, the compute device 100 (e.g., the media access circuitry 108) broadcasts (e.g., sends) the read subset of the input matrix A to other partitions in the memory media 110, as indicated in block 528. In the illustrative embodiment, the compute device 100 (e.g., the memory 104) reads a single subset from (e.g., one value) from matrix A, then proceeds to block 530 of FIG. 6, in which the compute device 100 performs, with the media access circuitry 108, one or more tensor operations on the matrix data that was accessed from the memory media 110, before looping back to read another subset of the matrix A.

Referring now to FIG. 6, in performing the tensor operation(s), the compute device 100, in the illustrative embodiment, performs the tensor operations using one or more compute logic units 136 (e.g., the compute logic units 318, 328, 338) associated with corresponding sets of partitions of the memory media 110, as indicated in block 532. Further, and as indicated in block 534, the compute device 100 may perform tensor operations concurrently across multiple compute logic units 136 (e.g., the compute logic units 318, 328, 338). As indicated in block 536, the media access circuitry 108, in the illustrative embodiment, performs the tensor operation(s) on matrix data in scratch pads included in the memory 104 (e.g., the scratch pads 132). In doing so, and as indicated in block 538, the media access circuitry 108 performs tensor operations on matrix data in scratch pads assigned to corresponding compute logic units in the media access circuitry 108 (e.g., multiplying, with the compute logic unit 318, the matrix data in the scratch pad 312 with the matrix data in the scratch pad 314, multiplying, with the compute logic unit 328, the matrix data in the scratch pad 322 with the matrix data in the scratch pad 324, etc.). As indicated in block 540, the tensor operation(s) may be matrix multiplication operations, and as indicated in block 542, the tensor operation(s) may be matrix multiply-accumulate operations. As indicated in block 544, the media access circuitry 108 may multiply an input matrix (e.g., matrix A) by a matrix of weight data (e.g., matrix B). Still referring to FIG. 6, in performing the tensor operation(s), the compute device 100 (e.g., the media access circuitry 108) may determine an outer product on read matrix data using the compute logic units 136 associated with the corresponding partitions and scratch pads, as indicated in block 546. For example, and as indicated in block 548, the compute device 100 (e.g., the media access circuitry 108) may determine, with the compute logic unit 136 associated with a given partition, an outer product using the weight matrix data (e.g., from matrix B) in the corresponding scratch pad 132 and the input matrix data (e.g., from matrix A) that has been broadcasted (e.g., from block 528). As described in more detail herein, after the compute device 100 determines the outer product using the weight matrix data (e.g., matrix B) in the scratch pads and the presently broadcasted subset (e.g., value) from matrix A, the compute device 100 may access another subset (e.g., value) from matrix A (e.g., in block 524), and perform the outer product using the matrix B data and the next broadcasted subset from matrix A, and so on.

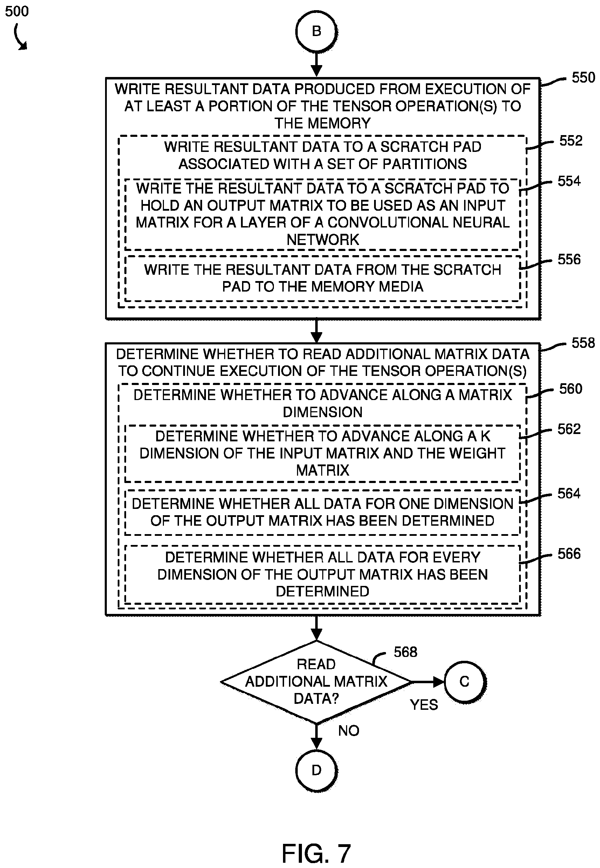

Referring now to FIG. 7, the compute device 100 (e.g., the media access circuitry 108) may write resultant data produced from execution of at least a portion of the tensor operation(s) to the memory 104 (e.g., to the memory media 110), as indicated in block 550. In doing so, and as indicated in block 552, the media access circuitry 108 may initially write the resultant data to one or more scratch pads, each associated with a set of partitions of the memory media 110 (e.g., adding, to the scratch pad 316, the result of a multiplication of input matrix A from the scratch pad 312 with the weight matrix B from the scratch pad 314, adding, to the scratch pad 326, the result of a multiplication of input matrix A from the scratch pad 322 with the weight matrix B from the scratch pad 324, etc.). As indicated in block 554, the media access circuitry 108 may write the resultant data to a scratch pad (e.g., the scratch pads 316, 326, 336) to each hold an output matrix (e.g., matrix C) that is to be used as an input matrix for a layer (e.g., a subsequent layer) of a convolutional neural network. As indicated in block 556, the media access circuitry 108 may write the resultant data from the scratch pad(s) 316, 326, 336 to the memory media 110 (e.g., to the corresponding partitions).

In block 558, the compute device 100 (e.g., the media access circuitry 108) determines whether to read additional matrix data to continue execution of the tensor operation(s). In doing so, the compute device 100 determines whether to advance along a matrix dimension, as indicated in block 560. For example, and as indicated in block 562, the compute device 100 (e.g., the media access circuitry 108) determines whether to advance along the K dimension of the input matrix (e.g., matrix A) and the weight matrix (e.g., matrix B). As indicated in block 564, the compute device 100 (e.g., the media access circuitry 108) determines whether all data for one dimension of the output matrix (e.g., the matrix C) has been determined (e.g., calculated). As indicated in block 566, the compute device 100 (e.g., the media access circuitry 108) may determine whether all data for every dimension of the output matrix (e.g., the matrix C) has been determined, as indicated in block 566. If all data for every dimension of the output matrix has been determined, then the compute device 100 (e.g., the media access circuitry 108), in the illustrative embodiment, determines not to read additional matrix data for the tensor operation(s) (e.g., the tensor operations are complete). Otherwise, the compute device 100 (e.g., the media access circuitry 108) determines that additional matrix data is to be read.

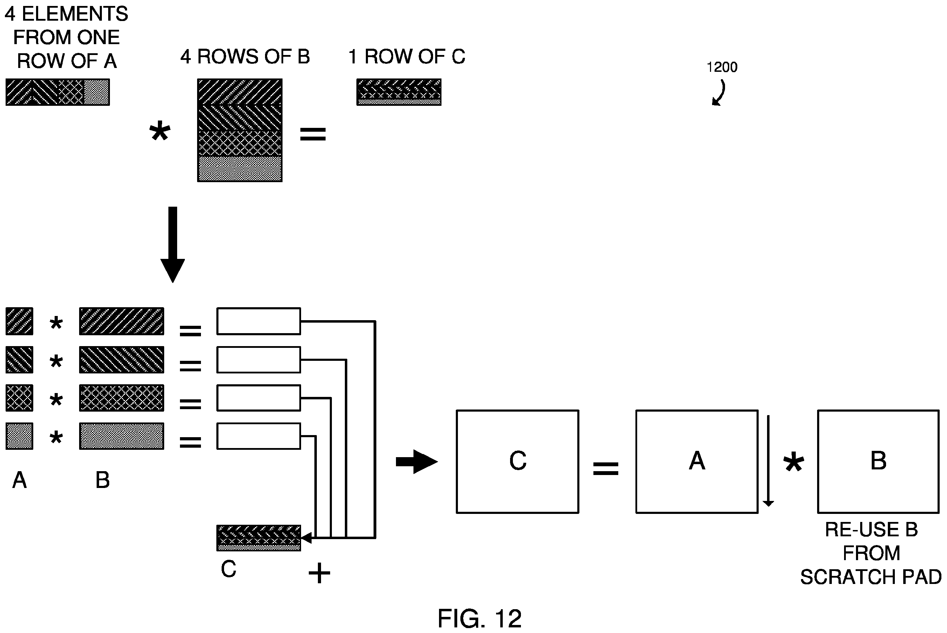

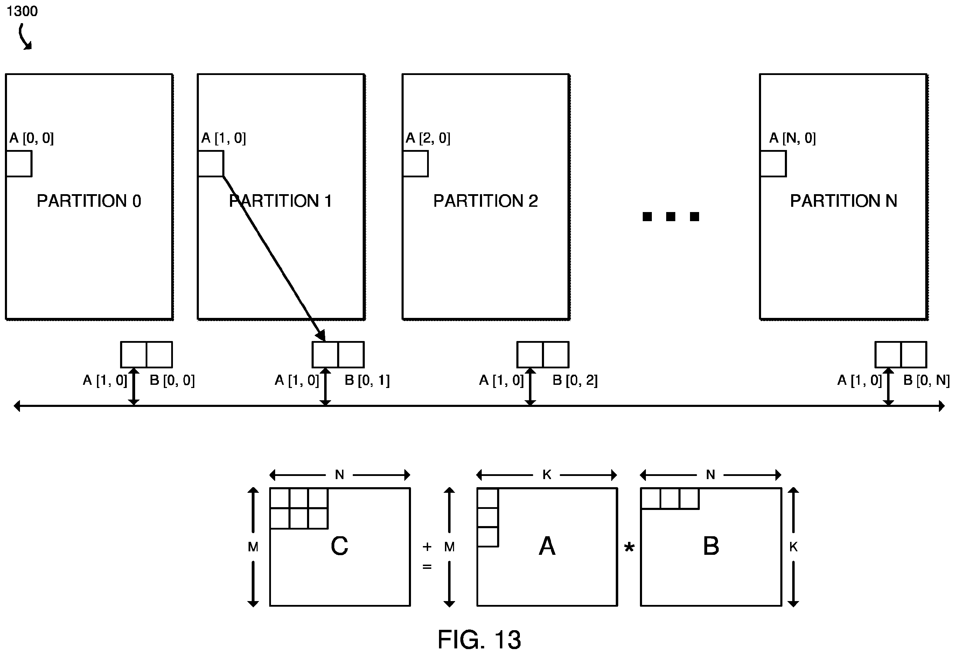

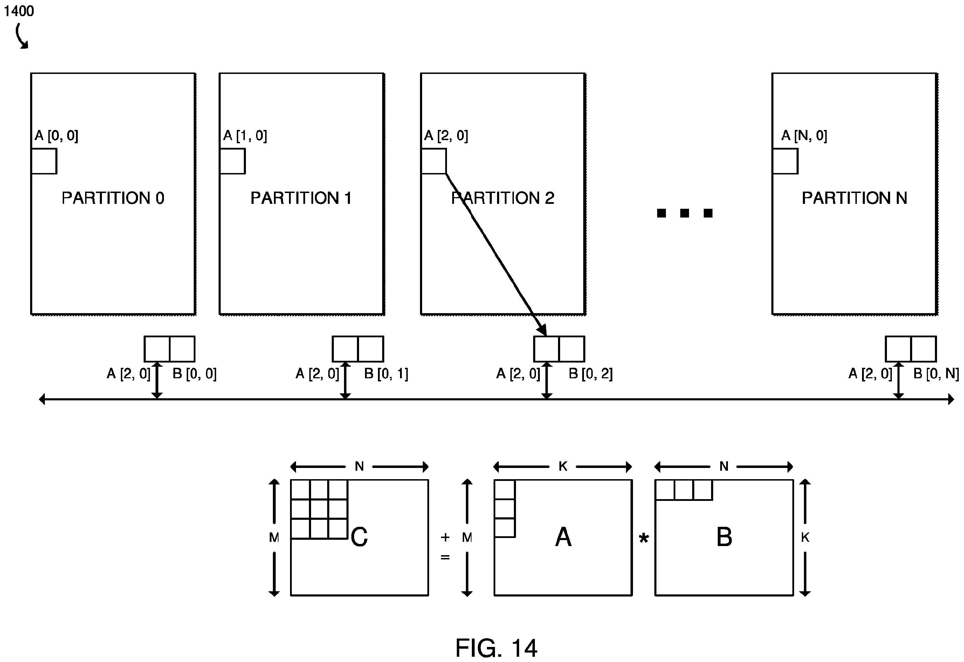

In block 568, the compute device 100 (e.g., the media access circuitry 108) determines the subsequent course of action based on whether the compute device 100 has determined to read additional matrix data or not (e.g., the determination from block 558). If the compute device 100 (e.g., the media access circuitry 108) has determined to read additional matrix data, the method 500 loops back to block 510 of FIG. 5, to access additional data from the weight matrix (e.g., matrix B) and/or the input matrix (e.g., matrix A). Referring now to FIG. 12, an example embodiment of an outer-product operation within each partition is shown in the diagram 1200. In the example, the matrix A has dimensions M and K, the matrix B has dimensions K and N, and the matrix C has dimensions M and N. In the example embodiment, M, N, and K are equal to 4. However, in other embodiments, the dimensions may be different. Within a partition, during each successive time period, a B_MxB_K matrix block of matrix A is multiplied by a B_KxB_N matrix block of matrix B to produce a B_MxB_N matrix block of matrix C. Each of the B_M rows of the matrix A block are multiplied with the same matrix B block. The amount of re-use of the matrix B block depends on the value of the B_M parameter. The scratch pad space utilized for the matrix B block is equal to B_KxB_N bytes per partition. Referring now to FIG. 13, as shown in the diagram 1300, after the first block (e.g., subset) of matrix A data (e.g., block A[0,0]) is read and broadcast to the other partitions, and the corresponding calculations are performed on the read matrix A data, the media access circuitry 108 reads the next block (e.g., subset) of matrix A data (e.g., block A[1,0], from Partition 1), broadcasts the read data to the other partitions, and performs the corresponding matrix calculations. Referring now to FIG. 14, as shown in the diagram 1400, in the subsequent time period, another block (e.g., block A[2,0]) is read from the next partition (e.g., Partition 2) and broadcast to the other partitions for computation. As such, if the number of partitions is 64, then for 64 time periods, a new block of matrix A is read from a corresponding one of each of the 64 partitions and broadcast to the other partitions for computation. The 128 time periods of reading matrices B and A, and performing the corresponding calculations, is referred to herein as an "epoch." During the first epoch, in the illustrative embodiment, a 64^{∗}4 x 64^{∗}4 (i.e., 512x512) region of matrix C is partially output.

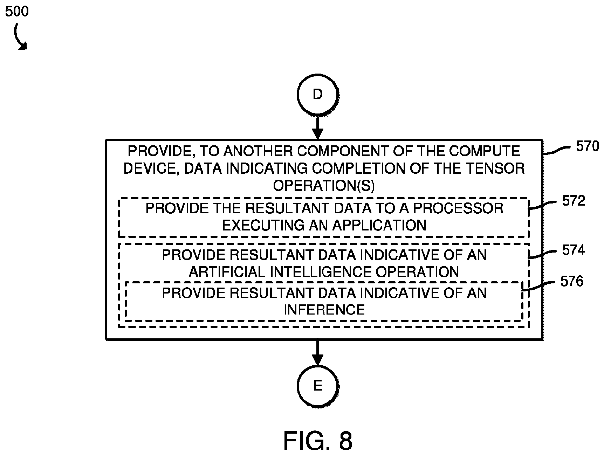

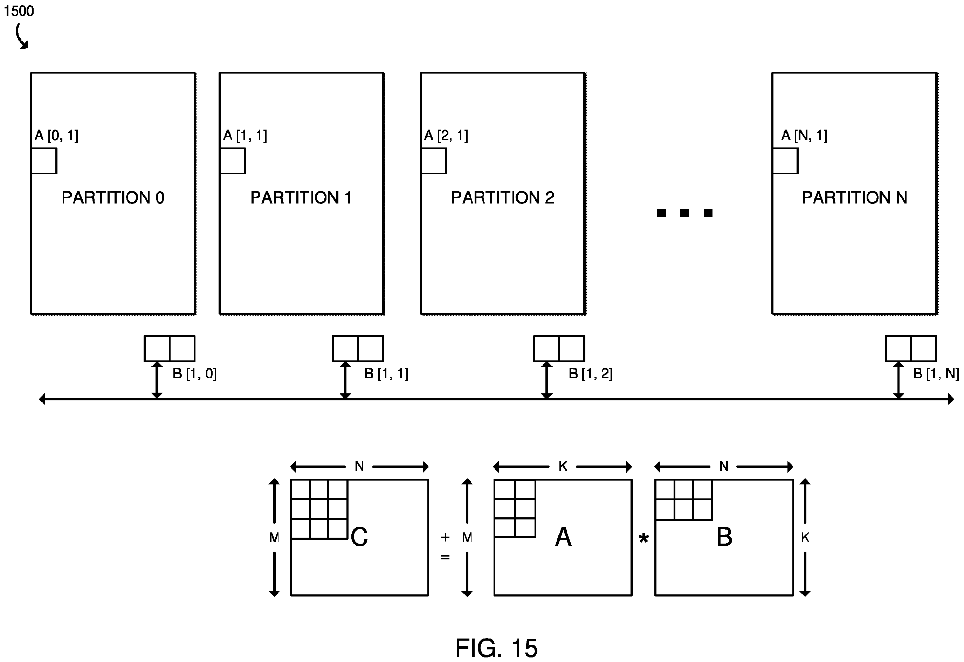

Referring now to FIG. 15, as indicated in the diagram 1500, the compute device 100 (e.g., the media access circuitry 108) subsequently moves down the K dimension of the A and B matrices and accumulates into matrix C. In the illustrative embodiment, in K/4 epochs, the 512x512 region of matrix C is fully completed. This time period is referred to herein as an "era." The compute device 100 (e.g., the media access circuitry 108), in the illustrative embodiment, takes multiple eras to complete the M dimension of matrix C, referred to herein as an "eon." Further, the compute device 100 (e.g., the media access circuitry 108) takes several eons to complete the N dimension of matrix C. In the example described above, the orchestration, together with the broadcast operations, enable a relatively large blocking size of 512x512 to be used. The amount of data reuse increases with the blocking size. As such, with relatively large blocking sizes, the elements of matrices A, B, and C are read and written relatively fewer times, resulting in lower energy usage to access matrix data. The broadcast operation increases the effective read bandwidth and given that all partitions participate in performing the tensor operation (e.g., matrix multiplication), the compute device 100 is able to achieve a higher performance and efficiency compared to typical compute devices executing tensor operations to support artificial intelligence applications. Referring back to FIG. 8, if no additional matrix data is to be read (e.g., the tensor operation(s) are complete) the method 500 advances to block 570 of FIG. 8, in which the compute device 100 (e.g., the memory 104) provides, to another component of the compute device 100, data indicating completion of the tensor operation(s) (e.g., an acknowledgement that the operation(s) are complete).

Referring now to FIG. 8, as indicated in block 572, the memory 104 may provide the resultant data to the processor 102, which may be executing an application that requested the tensor operation(s) to be performed (e.g., as described relative to block 506 of FIG. 5). As indicated in block 574, the memory 104, in the illustrative embodiment, provides resultant data indicative of an artificial intelligence operation (e.g., the output matrix C is indicative of the result of an artificial intelligence operation). For example, and as indicated in block 576, the memory 104 may provide resultant data indicative of an inference (e.g., an identification of an object in an image, etc.). Subsequently, the method 500 loops back to block 502 of FIG. 5, in which the compute device 100 determines whether to continue to enable efficient artificial intelligence operations (e.g., to perform further tensor operations pertaining to a subsequent layer of a convolutional neural network, to continue training a neural network, to produce another inference, etc.). Though many of the operations in the method 500 are described as being performed on partitions, it should be understood that in some embodiments, the operations may be performed on clusters (e.g., groups of partitions).

## Claims

1. A memory comprising:
media access circuitry (108) coupled to a memory media (110) having a cross point architecture, wherein the media access circuitry (108) comprises a plurality of scratch pads and multiple compute logic units, and is configured to:
access matrix data from the memory media (110), including:
reading, during each time period within a set of time periods, a different subset with dimensions B_K and B_N of one matrix (B) with dimensions K and N from a corresponding partition of N partitions (311 321 331) of the memory media (110),
writing each different subset of the one matrix (B) to a corresponding scratch pad (132; 314, 324, 334) associated with the corresponding partition (311, 321, 331),
reading, during each time period within another set of time periods, a different subset with dimensions B_M and B_K of another matrix (A) with dimensions M and K from a corresponding partition of N partitions (311, 321, 331) of the memory media (110),
writing each different subset of the other matrix (A) to a corresponding scratch pad (132; 312, 322, 332) associated with the corresponding partition (311, 312, 331),
broadcasting, in each time period, the read subset of the other matrix (A) to the scratch pads (132; 312, 322, 332) associated with the N-1 other partitions of the memory media (110);
perform, with each of the multiple compute logic units (136; 318, 328, 338) associated with the different N partitions (311, 321, 331) of the memory media (110), tensor operations on the matrix data in the scratch pads (132; 312, 314, 322, 324, 332, 334) associated with the partitions (311, 321, 331) the compute logic units (136; 318, 328, 338) are associated with; and
write, to the memory media (110), resultant data indicative of a result of the tensor operations.

2. The memory of claim 1, wherein to read a different subset of the one matrix comprises to read a different subset of a weight matrix (B).

3. The memory of claim 1, wherein to broadcast matrix data comprises to broadcast a subset of an input matrix (A).

4. The memory of claim 1, wherein to perform a tensor operation comprises to perform a matrix multiplication operation.

5. The memory of claim 1, wherein to perform a tensor operation comprises to determine an outer product based on i) matrix data from a weight matrix (B) that has been written to the corresponding scratch pad (132; 312, 322, 332) and ii) broadcasted matrix data from an input matrix (A).

6. A method comprising:
accessing, by a media access circuitry (108) included in a memory, matrix data from a memory media (110) coupled to the media access circuitry (108), including:
reading, during each time period within a set of time periods, a different subset with dimensions B_K and B_N of one matrix (B) with dimensions K and N from a corresponding partition of N partitions (311 321 331) of the memory media (110),
writing each different subset of the one matrix (B) to a corresponding scratch pad (132; 314, 324, 334) associated with the corresponding partition (311, 321, 331),
reading, during each time period within another set of time periods, a different subset with dimensions B_M and B_K of another matrix (A) with dimensions M and K from a corresponding partition of the N partitions (311, 321, 331) of the memory media (110),
writing each different subset of the other matrix (A) to a corresponding scratch pad (132; 312, 322, 332) associated with the corresponding partition (311, 312, 331),
broadcasting, in each time period, the read subset of the other matrix (A) to the scratch pads (132; 312, 322, 332) associated with the N-1 other partitions of the memory media (110);
performing, by each of multiple compute logic units (136; 318, 328, 338) associated with the N different partitions (311, 321, 331) of the memory media (110), tensor operations on the matrix data in the scratch pads (132; 312, 314, 322, 324, 332, 334) associated with the partitions (311, 321, 331) the compute logic units (136; 318, 328, 338) are associated with; and
writing, by the media access circuitry (108) and to the memory media (110), resultant data indicative of a result of the tensor operations.

7. The method of claim 6, wherein reading a different subset of a matrix comprises reading a different subset of a weight matrix (B).

8. The method of claim 6, wherein broadcasting matrix data comprises broadcasting a subset of an input matrix (A).

9. The method of claim 6, wherein performing a tensor operation comprises performing a matrix multiplication operation.

10. The method of claim 6, wherein performing a tensor operation comprises determining an outer product based on i) matrix data from a weight matrix (B) that has been written to a corresponding scratch pad (132; 312, 322, 332) and ii) broadcasted matrix data from an input matrix (A).

11. A computer readable medium comprising instructions which when executed by a computer comprising a memory according to claim 1 cause said computer to perform the method of any of claims 6-10.

## Patentansprüche

1. Speicher, der Folgendes umfasst:
eine Medienzugangsschaltung (108), die an ein Speichermedium (110) mit einer Kreuzpunktarchitektur gekoppelt ist, wobei die Medienzugangsschaltung (108) mehrere Zwischenregister und mehrere logische Recheneinheiten umfasst und konfiguriert ist zum:
Zugreifen auf Matrixdaten von dem Speichermedium (110), das enthält:
Lesen während jeder Zeitperiode innerhalb einer Gruppe von Zeitperioden einer anderen Untergruppe mit Dimensionen B_K und B_N einer Matrix (B) mit Dimensionen K und N von einer entsprechenden Partition von N Partitionen (311, 321, 331) des Speichermediums (110),
Schreiben jeder anderen Untergruppe der einen Matrix (B) in ein entsprechendes Zwischenregister (132; 314, 324, 334), das der entsprechenden Partition (311, 321, 331) zugeordnet ist,
Lesen während jeder Zeitperiode innerhalb einer anderen Gruppe von Zeitperioden einer anderen Untergruppe mit Dimensionen B_M und B_K einer anderen Matrix (A) mit Dimensionen M und K von einer entsprechenden Partition von N Partitionen (311, 321, 331) des Speichermediums (110);
Schreiben jeder anderen Untergruppe der anderen Matrix (A) in ein entsprechendes Zwischenregister (132; 312, 322, 332), das der entsprechenden Partition (311, 312, 331) zugeordnet ist,
Senden in jeder Zeitperiode der gelesenen Untergruppe der anderen Matrix (A) an die Zwischenregister (132; 312, 322, 332), die den N-1 anderen Partitionen des Speichermediums (110) zugeordnet sind;
Ausführen mit jeder der mehreren logischen Recheneinheiten (136; 318, 328, 338), die den verschiedenen N Partitionen (311, 321, 331) des Speichermediums (110) zugeordnet sind, von Tensoroperationen an den Matrixdaten in den Zwischenregistern (132; 312, 314, 322, 324, 332, 334), die den Partitionen (311, 321, 331) zugeordnet sind, denen die logischen Recheneinheiten (136; 318, 328, 338) zugeordnet sind; und
Schreiben in das Speichermedium (110) von Ergebnisdaten, die ein Ergebnis der Tensoroperationen angeben.

2. Speicher nach Anspruch 1, wobei, um eine andere Untergruppe der einen Matrix zu lesen, umfasst, eine andere Untergruppe einer Gewichtungsmatrix (B) zu lesen.

3. Speicher nach Anspruch 1, wobei, um Matrixdaten zu senden, umfasst, eine Untergruppe einer eingegebenen Matrix (A) zu senden.

4. Speicher nach Anspruch 1, wobei, um eine Tensoroperation auszuführen, umfasst, eine Matrixmultiplikationsoperation auszuführen.

5. Speicher nach Anspruch 1, wobei, um eine Tensoroperation auszuführen, umfasst, ein Kreuzprodukt anhand von i) Matrixdaten von einer Gewichtungsmatrix (B), die in das entsprechende Zwischenregister (132; 312, 322, 332) geschrieben wurde, zu bestimmen und ii) Matrixdaten von einer eingegebenen Matrix (A) zu senden.

6. Verfahren, das Folgendes umfasst:
Zugreifen durch eine Medienzugangsschaltung (108), die in einem Speicher enthalten ist, auf Matrixdaten von einem Speichermedium (110), das an die Medienzugangsschaltung (108) gekoppelt ist, das Folgendes enthält:
Lesen während jeder Zeitperiode innerhalb einer Gruppe von Zeitperioden einer anderen Untergruppe mit Dimensionen B_K und B_N einer Matrix (B) mit Dimensionen K und N von einer entsprechenden Partition von N Partitionen (311, 321, 331) des Speichermediums (110),
Schreiben jeder anderen Untergruppe der einen Matrix (B) in ein entsprechendes Zwischenregister (132; 314, 324, 334), das der entsprechenden Partition (311, 321, 331) zugeordnet ist,
Lesen während jeder Zeitperiode innerhalb einer anderen Gruppe von Zeitperioden einer anderen Untergruppe mit Dimensionen B_M und B_K einer anderen Matrix (A) mit Dimensionen M und K von einer entsprechenden Partition der N Partitionen (311, 321, 331) des Speichermediums (110),
Schreiben jeder anderen Untergruppe der anderen Matrix (A) in ein entsprechendes Zwischenregister (132; 312, 322, 332), das der entsprechenden Partition (311, 312, 331) zugeordnet ist;
Senden in jeder Zeitperiode der gelesene Untergruppe der anderen Matrix (A) an die Zwischenregister (132; 312, 322, 332), die den N-1 anderen Partitionen des Speichermediums (110) zugeordnet sind;
Ausführen durch jede von mehreren logischen Recheneinheiten (136; 318, 328, 338), die den N verschiedenen Partitionen (311, 321, 331) des Speichermediums (110) zugeordnet sind, von Tensoroperationen an den Matrixdaten in den Zwischenregistern (132; 312, 314, 322, 324, 332, 334), die den Partitionen (311, 321, 331) zugeordnet sind, denen die logischen Recheneinheiten (136; 318, 328, 338) zugeordnet sind; und
Schreiben durch die Medienzugangsschaltung (108) und in das Speichermedium (110) von Ergebnisdaten, die ein Ergebnis der Tensoroperationen angeben.

7. Verfahren nach Anspruch 6, wobei das Lesen einer anderen Untergruppe einer Matrix umfasst, eine andere Untergruppe einer Gewichtungsmatrix (B) zu lesen.

8. Verfahren nach Anspruch 6, wobei das Senden von Matrixdaten umfasst, eine Untergruppe einer eingegebenen Matrix (A) zu senden.

9. Verfahren nach Anspruch 6, wobei das Ausführen einer Tensoroperation umfasst, eine Matrixmultiplikationsoperation auszuführen.

10. Verfahren nach Anspruch 6, wobei das Ausführen einer Tensoroperation umfasst, ein Kreuzprodukt anhand von i) Matrixdaten von einer Gewichtungsmatrix (B), die in ein entsprechendes Zwischenregister (132; 312, 322, 332) geschrieben wurde, zu bestimmen und ii) Matrixdaten von einer eingegebenen Matrix (A) zu senden.

11. Computerlesbares Medium, das Anweisungen umfasst, die dann, wenn sie durch einen Computer, der einen Speicher nach Anspruch 1 umfasst, ausgeführt werden, bewirken, dass der Computer das Verfahren nach einem der Ansprüche 6-10 ausführt.

## Revendications

1. Mémoire comprenant :
des circuits d'accès au support (108) couplés à un support de mémoire (110) ayant une architecture à points de croisement, où les circuits d'accès au support (108) comprennent une pluralité de blocs-notes et de multiples unités logiques de calcul, et sont configurés pour :
accéder à des données de matrice à partir du support de mémoire (110), y compris :
lire, pendant chaque période de temps dans un ensemble de périodes de temps, un sous-ensemble différent avec des dimensions B_K et B_N d'une matrice (B) ayant des dimensions K et N à partir d'une partition correspondante de N partitions (311, 321, 331) du support de mémoire (110),
écrire chaque sous-ensemble différent de la matrice (B) sur un bloc-notes correspondant (132 ; 314, 324, 334) associé à la partition correspondante (311, 321, 331), lire, pendant chaque période de temps dans un autre ensemble de périodes de temps, un sous-ensemble différent avec des dimensions B_M et B_K d'une autre matrice (A) ayant des dimensions M et K à partir d'une partition correspondante de N partitions (311, 321, 331) du support de mémoire (110),
écrire chaque sous-ensemble différent de l'autre matrice (A) sur un bloc-notes correspondant (132 ; 312, 322, 332) associé à la partition correspondante (311, 312, 331),
diffuser, dans chaque période de temps, le sous-ensemble lu de l'autre matrice (A) vers les blocs-notes (132 ; 312, 322, 332) associés aux N-1 autres partitions du support de mémoire (110) ;
exécuter, avec chacune des multiples unités logiques de calcul (136 ; 318, 328, 338) associées aux N différentes partitions (311, 321, 331) du support de mémoire (110), des opérations tensorielles sur les données de matrice dans les blocs-notes (132 ; 312, 314, 322, 324, 332, 334) associés aux partitions (311, 321, 331) auxquelles les unités logiques de calcul (136 ; 318, 328, 338) sont associées ; et
écrire, sur le support de mémoire (110), des données résultantes indicatives d'un résultat des opérations tensorielles.

2. Mémoire selon la revendication 1, dans laquelle la lecture d'un sous-ensemble différent de la matrice comprend la lecture d'un sous-ensemble différent d'une matrice de poids (B).

3. Mémoire selon la revendication 1, dans laquelle la diffusion de données de matrice comprend la diffusion d'un sous-ensemble d'une matrice d'entrée (A).

4. Mémoire selon la revendication 1, dans laquelle l'exécution d'une opération tensorielle comprend l'exécution d'une opération de multiplication matricielle.

5. Mémoire selon la revendication 1, dans laquelle l'exécution d'une opération tensorielle comprend la détermination d'un produit externe sur la base i) de données matricielles provenant d'une matrice de poids (B) qui a été écrite sur le bloc-notes correspondant (132 ; 312, 322, 332) et ii) de données matricielles diffusées provenant d'une matrice d'entrée (A).

6. Procédé comprenant les étapes suivantes :
accéder, par des circuits d'accès au support (108) inclus dans une mémoire, à des données de matrice depuis un support de mémoire (110) couplé aux circuits d'accès au support (108), y compris :
lire, pendant chaque période de temps dans un ensemble de périodes de temps, un sous-ensemble différent avec des dimensions B_K et B_N d'une matrice (B) ayant des dimensions K et N à partir d'une partition correspondante de N partitions (311, 321, 331) du support de mémoire (110),
écrire chaque sous-ensemble différent de la matrice (B) sur un bloc-notes correspondant (132 ; 314, 324, 334) associé à la partition correspondante (311, 321, 331), lire, pendant chaque période de temps dans un autre ensemble de périodes de temps, un sous-ensemble différent avec des dimensions B_M et B_K d'une autre matrice (A) ayant des dimensions M et K à partir d'une partition correspondante de N partitions (311, 321, 331) du support de mémoire (110),
écrire chaque sous-ensemble différent de l'autre matrice (A) sur un bloc-notes correspondant (132 ; 312, 322, 332) associé à la partition correspondante (311, 312, 331),
diffuser, dans chaque période de temps, le sous-ensemble lu de l'autre matrice (A) vers les blocs-notes (132 ; 312, 322, 332) associés aux N-1 autres partitions du support de mémoire (110) ;
exécuter, par chacune des multiples unités logiques de calcul (136 ; 318, 328, 338) associées aux N différentes partitions (311, 321, 331) du support de mémoire (110), des opérations tensorielles sur les données de matrice dans les blocs-notes (132 ; 312, 314, 322, 324, 332, 334) associés aux partitions (311, 321, 331) auxquelles les unités logiques de calcul (136 ; 318, 328, 338) sont associées ; et
écrire, par les circuits d'accès au support (108) et sur le support de mémoire (110), des données résultantes indicatives d'un résultat des opérations tensorielles.

7. Procédé selon la revendication 6, dans lequel la lecture d'un sous-ensemble différent d'une matrice comprend la lecture d'un sous-ensemble différent d'une matrice de poids (B).

8. Procédé selon la revendication 6, dans lequel la diffusion de données de matrice comprend la diffusion d'un sous-ensemble d'une matrice d'entrée (A).

9. Procédé selon la revendication 6, dans lequel l'exécution d'une opération tensorielle comprend l'exécution d'une opération de multiplication matricielle.

10. Procédé selon la revendication 6, dans lequel l'exécution d'une opération tensorielle comprend la détermination d'un produit externe sur la base i) de données matricielles provenant d'une matrice de poids (B) qui a été écrite sur le bloc-notes correspondant (132 ; 312, 322, 332) et ii) de données matricielles diffusées provenant d'une matrice d'entrée (A).

11. Support lisible par ordinateur comprenant des instructions qui, lorsqu'elles sont exécutées par un ordinateur comprenant une mémoire selon la revendication 1, amènent ledit ordinateur à exécuter le procédé de l'une quelconque des revendications 6 à 10.
